# EUROPÄISCHE PATENTSCHRIFT

(11) **EP 2 684 246 B1**
(45) Veröffentlichungstag und Bekanntmachung des Hinweises auf die Patenterteilung: **20.04.2016**
(21) Anmeldenummer: 12704691.0
(22) Anmeldetag: 15.02.2012
(51) Int. Cl.: H01M 2/34, H01M 10/42, H01M 10/48, B60L 3/00, B60L 3/04, B60L 11/18, H02J 7/00, G01R 31/04, H01M 10/44

(54) **BATTERIE FÜR EIN FAHRZEUG UND VERFAHREN ZUM BETREIBEN EINER SOLCHEN BATTERIE**
BATTERIE FOR A VEHICLE AND METHOD FOR OPERATING SUCH A BATTERIE
BATTÉRIE POUR UN VÉHICULE ET PROCÉDÉ DE FONCTIONNEMENT D'UNE TELLE BATTÉRIE

(30) Priorität: 09.03.2011 DE 102011013394
(43) Veröffentlichungstag der Anmeldung: 15.01.2014
(73) Patentinhaber: Audi AG, 85045 Ingolstadt (DE)
(72) Erfinder: ACHHAMMER, Siegfried, 93049 Regensburg (DE)
(74) Vertreter: Herbst, Matthias Heinz
(86) Internationale Anmeldenummer: PCT/EP2012/000649
(87) Internationale Veröffentlichungsnummer: WO 2012/119692

(56) Entgegenhaltungen:
- EP-A1- 2 234 238
- JP-A- 9 035 753
- US-A- 3 509 444
- US-A- 5 033 112

## Beschreibung

Die Erfindung betrifft eine Batterie für ein Fahrzeug mit einer Mehrzahl von Batteriezellen, welche einen Zellstapel bilden. Über wenigstens eine Leitung ist im Betrieb der Batterie elektrische Energie aus dem Zellstapel entnehmbar oder in den Zellstapel einbringbar. Des Weiteren betrifft die Erfindung ein Verfahren zum Betreiben einer solchen Batterie.

Bei Hochvoltbatterien für Fahrzeuge, insbesondere bei Traktionsbatterien auf Lithium-Ionen-Basis, kann es bei einer sehr starken Erhitzung zu schweren Funktionsstörungen oder gar zu einer Gefährdung von Menschen kommen. Um zu verhindern, dass es zu einer lokalen großen Hitzeentwicklung kommt, werden lösbare Verbindungen von Leitungen innerhalb der Batterie sorgfältig ausgeführt. So wird bei geschraubten Verbindungsstellen auf die Einhaltung eines vorbestimmten Anschraubmoments geachtet. Bei Klemmverbindungen oder Crimpverbindungen wird auf eine hohe Qualität von Kabelschuhen und Steckkontakten geachtet, um eine lösbare Verbindungsstelle mit einem besonders geringen elektrischen Widerstand zu schaffen. Dadurch soll sichergestellt werden, dass auch bei rauen Betriebsbedingungen der Batterie, welche elektrischen Strom hoher Stromstärke und eine hohe Leistung abgibt, über deren gesamte Lebensdauer hinweg möglichst keine lokalen Überhitzungen auftreten. Solche Überhitzungen können sich beispielsweise an einer locker werdenden Verbindungsstelle einstellen.

Die EP 2 234 238 A1 beschreibt ein elektrisches System eines Hybridfahrzeugs mit einer Energiespeichereinrichtung, welche über ein Hauptrelais mit einem Wandler verbunden ist. Über das Hauptrelais kann die Energiespeichereinrichtung mit dem den Wandler umfassenden elektrischen System verbunden oder von diesem getrennt werden.

Die US 5 033 112 A beschreibt ein System mit einer Spannungsquelle, welche eine Spannung von 110 V oder über einen Wandler eine Spannung von 48 V bereitstellen kann. Über Leitungen können diese Spannungen zunächst einer Kontrollschnittstelle und von dieser Anschlussdosen zugeführt werden. In der jeweiligen Leitung verläuft parallel zu elektrischen Leitern eine optische Faser, und jede Anschlussdose umfasst einen Stecker und eine Steckdose. Über die optische Faser können Informationen betreffend die für ein jeweiliges Gerät notwendige Spannung, Stromstärke, Frequenz und Betriebstemperatur zwischen dem mit dem Stecker verbundenen Gerät und der Kontrollschnittstelle ausgetauscht werden. Im Bereich des mit der Steckdose verbundenen Steckers ist ein optischer Koppler vorgesehen, über welchen Signale von der optischen Faser in der Steckdose in die optische Faser im Stecker eingekoppelt und auch in die umgekehrte Richtung übermittelt werden können. Der Stromfluss durch die Leitung wird überwacht. Wenn die von dem Gerät bezogene Leistung von den Vorgaben abweicht, können die Leistung abgeschaltet und ein Alarm ausgegeben werden.

Die JP 09 035 753 A beschreibt eine Schaltungsanordnung für eine Batterie, wobei ein erster Spannungsmesser einen Strom misst, welcher zwischen zwei mit den beiden Batteriepolen verbundenen Kontaktstiften über einen Messwiderstand fließt. Ein zweiter Spannungsmesser erfasst über zwei weitere, ebenfalls mit den beiden Batteriepolen gekoppelte Kontaktstifte die an diesen beiden Kontaktstiften anliegende Spannung. So kann der Kontaktwiderstand der Kontaktstifte bestimmt werden. Eine solche Schaltungsanordnung zum Erfassen des Kontaktwiderstands mittels zweier Spannungsmesser ist sehr aufwändig.

Aufgabe der vorliegenden Erfindung ist es daher, eine Batterie sowie ein Verfahren der eingangs genannten Art zu schaffen, welche bzw. welches auf einfache Weise einen besonders sicheren Betrieb der Batterie ermöglicht.

Diese Aufgabe wird durch eine Batterie mit den Merkmalen des Patentanspruchs 1 und durch ein Verfahren mit den Merkmalen des Patentanspruchs 10 gelöst. Vorteilhafte Ausgestaltungen mit zweckmäßigen Weiterbildungen der Erfindung sind in den abhängigen Patentansprüchen angegeben.

Bei der erfindungsgemäßen Batterie ist zum Überwachen eines an zumindest einer lösbaren Verbindungsstelle der wenigstens einen Leitung mit einer weiteren Komponente der Batterie vorliegenden Widerstands wenigstens eine Überwachungseinrichtung vorgesehen, welche derart in einem Parallelzweig zu der zumindest einen Verbindungsstelle angeschlossen ist, dass bei stromführender Verbindungsstelle an dem Parallelzweig eine Spannung abfällt, wenn der Übergangswiderstand an der lösbaren Verbindungsstelle einen zulässigen Höchstwert überschreitet. So kann mittels der Überwachungseinrichtung festgestellt werden, ob an der Verbindungsstelle der Leitung ein unzulässig hoher Übergangswiderstand auftritt, welcher in der Folge zu einer unerwünschten Überhitzung der Verbindungsstelle führen könnte.

Die bei einer Traktionsbatterie, insbesondere einer Lithium-Ionen-Batterie, üblicherweise vorgesehenen Einrichtungen zur Erfassung der Temperatur und elektrischer Größen sind aufgrund von nicht ausreichend hoher Messgenauigkeit nicht dazu geeignet, den an lösbaren Verbindungsstellen der Leitung jeweils vorliegenden Übergangswiderstand zu erfassen. Beispielsweise führt bei einer Gesamtspannung des Zellstapels von 300 Volt eine Ungenauigkeit der Messung von 2,5 % zu einem Fehler von bis zu 7,5 Volt. Eine solche Spannung kann an der lösbaren Verbindungsstelle der Leitung zu einer starken Erhitzung führen, ohne dass dies mittels einer Messeinrichtung detektierbar wäre, welche die Spannung des Zellstapels erfasst.

Dadurch dass vorliegend an der lösbaren Verbindungsstelle eine Überwachungseinrichtung vorgesehen ist, welche ein Ansteigen des Übergangswiderstands an der Verbindungsstelle über einen zulässig hohen Wert hinaus erfassen kann, können vorliegend rechtzeitig Gegenmaßnahmen eingeleitet werden, wenn der Widerstand einen zulässigen Höchstwert überschreitet. Dadurch kann auf einfache Weise ein über die Lebensdauer der Batterie hinweg besonders sicherer Betrieb derselben gewährleistet werden.

Ist die Überwachungseinrichtung als analoger Spannungsmesser ausgeführt, so bringt das Vorsehen eines Analog-Digital-Wandlers und einer Potentialtrennstelle zwischen der Hochvoltbatterie und einem mit geringerer Spannung betriebenen Steuergerät einen vergleichsweise hohen Aufwand und entsprechende Kosten mit sich.

Gemäß einer besonders vorteilhaften Ausgestaltung der Erfindung umfasst daher die wenigstens eine Überwachungseinrichtung einen Optokoppler, dessen optischer Sender parallel zu der Verbindungsstelle geschaltet ist. Solange an der lösbaren Verbindungsstelle der Leitung ein geringer Übergangswiderstand vorliegt, fließt bei stromführender Verbindungsstelle kein Strom durch den Parallelzweig des Optokopplers, und der optische Sender sendet kein Licht aus. Steigt jedoch der Übergangswiderstand an der lösbaren Verbindungsstelle auf einen unzulässig hohen Wert an, so fällt bei stromführender Verbindungsstelle an dem den optischen Sender aufweisenden Parallelzweig des Optokopplers eine ausreichend große Spannung ab, sodass der optische Sender Licht aussendet. Dieses wird dann von einem Fotosensor des Optokopplers erfasst und zur Erzeugung eines Signals genutzt, welches detektiert wird. Durch den Optokoppler ist auf einfache und kostengünstige Art und Weise eine Potentialtrennstelle zwischen der Leitung der Hochvoltbatterie und einer das Signal erfassenden Auswerteeinrichtung realisiert.

In einer vorteilhaften Ausgestaltung der Erfindung ist ein bidirektionaler Optokoppler vorgesehen, sodass sowohl beim Laden als auch beim Entladen der Batterie das Auftreten eines unzulässig hohen Übergangswiderstands an der lösbaren Verbindungsstelle der Leitung erfasst werden kann.

Um einen Spannungswert festzulegen, bei dessen Überschreiten der optische Sender Licht aussendet, kann gemäß einer weiteren Ausführungsform dem optischen Sender des Optokopplers wenigstens ein Widerstandselement vorgeschaltet sein. Das Widerstandselement kann insbesondere zuschaltbar sein, so dass eine Auslöseschwelle des optischen Senders variiert werden kann.

Es können auch mit nur einer Überwachungseinrichtung mehrere in Reihe geschaltete Verbindungsstellen überwacht werden. Hierfür ist gemäß einer weiteren vorteilhaften Ausgestaltung der Erfindung die Überwachungseinrichtung derart in dem Parallelzweig an die Leitung angeschlossen, dass mittels der Überwachungseinrichtung der Widerstand wenigstens zweier in Reihe geschalteter Verbindungsstellen überwachbar ist. So kann mit besonders geringem Aufwand ein Leitungsbereich kontrolliert werden, in welchem mehrere Verbindungsstellen vorliegen und von denen wenigstens eine einen unzulässig hohen Übergangswiderstand aufweist.

Als weiter vorteilhaft hat es sich gezeigt, wenn die wenigstens eine Überwachungseinrichtung mit einer Steuerungseinrichtung gekoppelt ist, mittels welcher die Abgabe elektrischer Energie aus dem Zellstapel verringerbar ist. Dadurch kann eine automatische Verringerung der von dem Zellstapel abgegebenen elektrischen Energie vorgenommen werden, sobald an wenigstens einer lösbaren Verbindungsstelle der Leitung ein zu hoher Übergangswiderstand detektiert wird. Es kann insbesondere vorgesehen sein, die Abgabe elektrischer Energie des Zellstapels auf einen Wert Null zu verringern, also das Batteriesystem abzuschalten, wenn die Überwachungseinrichtung einen zu hohen Widerstandswert an der lösbaren Verbindungsstelle der Leitung erfasst. Alternativ kann vorgesehen sein, die von dem Zellstapel abgegebene elektrische Energie auf einen Wert zu verringern, welcher zum Fortbewegen des Fahrzeugs gerade ausreicht, so dass das Fahrzeug in einem Notlaufmodus (limp home mode) nach Hause oder zu einer Servicestation oder Werkstatt gefahren werden kann.

In einer weiteren vorteilhaften Ausgestaltung der Erfindung ist die weitere Komponente der Batterie ein Leitungszweig, welcher an ein mit einem Batteriepol des Zellstapels gekoppeltes Verbindungsstück angeschlossen ist. An einer solchen Stelle ist nämlich das Vorsehen einer geschraubten oder gesteckten Verbindung üblich, sodass es für den sicheren Betrieb der Batterie sinnvoll ist, hier ein eventuelles Ansteigen des Übergangswiderstands zu überwachen.

Von Vorteil ist es weiterhin, wenn die weitere Komponente wenigstens ein Schütz der Batterie ist, wobei die Überwachungseinrichtung in einem Parallelzweig zu einem zellstapelseitigen Anschluss des Schützes angeschlossen ist. Auf diese Weise kann die sichere Verbindung vom Zellstapel hin zum Schütz überwacht werden. Zusätzlich oder alternativ kann die Überwachungseinrichtung in einem Parallelzweig zu einem ausgangsseitigen Anschluss des Schützes angeschlossen sein, welcher mit einem Hochvoltanschluss der Batterie gekoppelt ist. Dann kann auch dieser Anschluss des Schützes hinsichtlich eines gegebenenfalls ansteigenden Übergangswiderstandes überwacht werden.

Es kann auch nur eine Überwachungseinrichtung in einem Parallelzweig zu einem beide Anschlüsse des Schützes umfassenden Laststrompfad des Schützes angeordnet sein. So können die Übergangswiderstände sowohl beider Anschlüsse des Schützes als auch interner Kontakte desselben überwacht werden. Dies ermöglicht es, ein Ansteigen des Widerstands des geschlossenen Schützes auf unerwünscht hohe Werte festzustellen.

Die weitere Komponente der Batterie kann auch einen Schutzstecker umfassen, mittels welchem eine elektrische Verbindung innerhalb des Zellstapels unterbrochen werden kann. Ein solcher Schutzstecker, weicher auch als Wartungsstecker bezeichnet wird, kann gezogen werden, wenn bei einer Wartung sichergestellt werden soll, dass der Stromkreis innerhalb des Zellstapels unterbrochen ist. Ein solcher Schutzstecker kann ebenfalls Steckverbindungen oder Schraubverbindungen aufweisen, und auch an diesen lösbaren Verbindungsstellen auftretende hohe Übergangswiderstände können zu einer unerwünschten Überhitzung führen. Daher ist auch hier das Überwachen des Übergangswiderstands mittels der in einem Parallelzweig zu Kontaktstellen angeschlossenen Überwachungseinrichtung von Vorteil.

Schließlich hat es sich als vorteilhaft gezeigt, wenn die weitere Komponente der Batterie eine mit dem Schutzstecker gekoppelte oder in den Schutzstecker integrierte Sicherung umfasst. Eine solche, optionale Sicherung ist nämlich üblicherweise mit dem Schutzstecker über eine gesteckte Verbindung gekoppelt, deren Übergangswiderstand so überwacht werden kann.

Bei dem erfindungsgemäßen Verfahren zum Betreiben einer Batterie für ein Fahrzeug bildet eine Mehrzahl von Batteriezellen einen Zellstapel, und es wird über wenigstens eine Leitung elektrische Energie aus dem Zellstapel entnommen oder in den Zellstapel eingebracht. Hierbei wird ein an zumindest einer lösbaren Verbindungsstelle der wenigstens einen Leitung vorliegender Widerstand mittels einer Überwachungseinrichtung überwacht, welche derart in einem Parallelzweig zu der zumindest einen Verbindungsstelle angeschlossen ist, dass bei stromführender Verbindungsstelle an dem Parallelzweig eine Spannung abfällt, wenn der Übergangswiderstand an der lösbaren Verbindungsstelle einen zulässigen Höchstwert überschreitet. Dadurch kann beim Betrieb der Batterie permanent der Übergangswiderstand an zumindest einer lösbaren Verbindungsstelle der Leitung überwacht werden, sodass bei Stromfluss durch die Verbindungsstelle ein Ansteigen des Übergangswiderstands auf unzulässig hohe Werte rechtzeitig erkannt wird. Dies ermöglicht einen besonders sicheren Betrieb der Batterie.

Die für die erfindungsgemäße Batterie beschriebenen Vorteile und bevorzugten Ausführungsformen gelten auch für das erfindungsgemäße Verfahren.

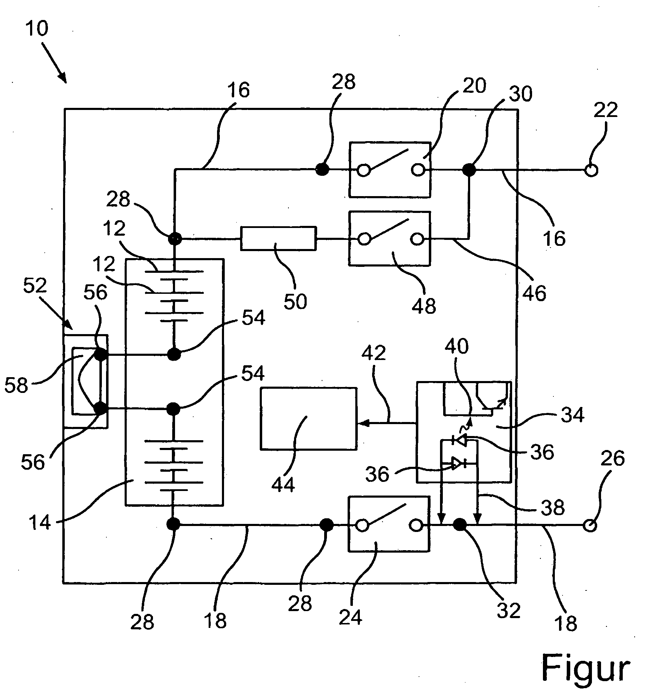

Die vorstehend in der Beschreibung genannten Merkmale und Merkmalskombinationen sowie die nachfolgend in der Figurenbeschreibung genannten und/oder in der Figur alleine gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen.

Weitere Vorteile, Merkmale und Einzelheiten der Erfindung ergeben sich aus den Ansprüchen, der nachfolgenden Beschreibung bevorzugter Ausführungsformen sowie anhand der Zeichnung.

Diese zeigt stark schematisiert eine Hochvoltbatterie für ein Fahrzeug, bei welcher der an geschraubten oder gesteckten Verbindungsstellen von Leitungen auftretende Übergangswiderstand während einer Stromabgabe oder Stromaufnahme der Hochvoltbatterie laufend überwacht wird.

Eine Hochvolt-Batterie 10, welche als Traktionsbatterie in einem Kraftfahrzeug zum Einsatz kommt, umfasst eine Mehrzahl von Batteriezellen 12, welche einen Zellstapel 14 bilden. Jeweilige Verbindungsleitungen 16, 18 verbinden Batteriepole des Zellstapels 14 mit einem ersten Hauptschütz 20, welches mit einem positiven Hochvoltanschluss 22 der Batterie 10 gekoppelt ist, und mit einem zweiten Hauptschütz 24, welches mit einem negativen Hochvoltanschluss 26 der Batterie 10 gekoppelt ist.

Die erste Verbindungsleitung 16 ist an jeweiligen Verbindungsstellen 28 mit dem Batteriepol des Zellstapels 14 einerseits und dem Hauptschütz 20 andererseits gekoppelt, wobei die Verbindungsstellen 28 als geschraubte oder gesteckte Verbindungen ausgebildet sein können.

Analoge Verbindungsstellen 28 stellen den Anschluss der zweiten Verbindungsleitung 18 an den anderen Batteriepol des Zellstapels 14 und den zweiten Hauptschütz 24 sicher. Auch eine Verbindungsstelle 30, 32 des jeweiligen Hauptschützes 20, 24 an den diesem zugeordneten Hochvoltanschluss 22, 26 ist als geschraubte oder gesteckte Verbindung der jeweiligen Verbindungsleitung 16, 18 ausgebildet.

Derartige Verbindungsstellen 28, 30, 32 können, etwa weil sie sich lockern oder aufgrund von Abnutzung, hohe Übergangswiderstände aufweisen. Ein solcher hoher Übergangswiderstand kann zu einer unerwünschten Überhitzung führen, welche zu einer erheblichen Funktionsstörung der Batterie 10 und schlimmstenfalls zu einem Brand derselben führen kann. Vorliegend wird daher überwacht, ob an den lösbaren Verbindungsstellen 28, 30, 32 ein unzulässig hoher Widerstand vorliegt.

Hierfür ist als Überwachungseinrichtung ein jeweiliger Optokoppler 34 vorgesehen, dessen Leuchtdioden 36 in einem Parallelzweig 38 zu der jeweiligen Verbindungsstelle 28, 30, 32 angeordnet sind. Vorliegend ist lediglich die Verschaltung eines solchen Optokopplers 34 beispielhaft an der Verbindungsstelle 32 gezeigt, jedoch sind für alle Verbindungsstellen 28, 30, 32 entsprechende Überwachungen der Übergangswiderstände bevorzugt.

Der Parallelzweig 38 kann auch parallel zu den in Reihe geschalteten Verbindungsstellen 28, 32 an die Verbindungsleitung 18 angeschlossen sein. Dann reicht ein Optokoppler 34 aus, um sowohl beide Anschlüsse des Hauptschützes 24 als auch die im Inneren des Hauptschützes 24 vorgesehenen Kontakte zu überwachen. Zusätzlich kann auch die Verbindungsstelle 28 der Leitung 18 an ein mit dem Batteriepol des Zellstapels 14 gekoppeltes Verbindungsstück mittels desselben Optokopplers 34 überwacht werden.

Insbesondere, wenn mittels eines einzigen Optokopplers 34 mehrere in Reihe geschaltete Verbindungsstellen 28, 32 überwacht werden sollen, kann den Leuchtdioden 36 desselben wenigstens ein Widerstandselement vorgeschaltet sein, um die Auslöseschwelle der Leuchtdioden 36 einzustellen. So kann vorgesehen sein, dass die jeweilige Leuchtdiode 36 des Optokopplers 34 erst bei einer höheren an dieser abfallenden Spannung Licht aussendet, wenn der Parallelzweig 38 parallel zu einer Mehrzahl von Verbindungsstellen 28, 32 an die Verbindungsleitung 18 angeschlossen ist, als dies der Fall ist, wenn der Optokoppler 34 nur eine Verbindungsstelle 32 überwacht.

Der Optokoppler 34 ist vorliegend als bidirektionaler Optokoppler 34 ausgebildet, sodass der an der Verbindungsstelle 32 vorliegende Widerstand sowohl beim Beladen als auch beim Entladen des Zellstapels 14 erfasst werden kann. Wenn die Verbindungsstelle 32 einen geringen Übergangswiderstand aufweist, so fliest kein Strom über die jeweilige Leuchtdiode 36. Steigt jedoch der Übergangswiderstand an der Verbindungsstelle 32 auf einen unzulässig hohen Wert an, so fällt an einem (nicht gezeigten) Widerstandselement, welches der jeweiligen Leuchtdiode 36 vorgeschaltet ist, eine so hohe Spannung ab, dass die Leuchtdiode 36 aufleuchtet. Ein Fotosensor 40 des Optokopplers 34 erfasst das von der Leuchtdiode 36 ausgesendete Licht und gibt über eine Signalleitung 42 ein entsprechendes Signal an ein Steuergerät 44 ab. Das Steuergerät 44 sorgt dann dafür, dass der Zellstapel 14 weniger elektrische Energie oder keine elektrische Energie mehr abgibt. Der Optokoppler 34 kann in das Steuergerät 44 integriert sein.

In einer Nebenleitung 46 ist parallel zu dem Hauptschütz 20 ein Vorladeschütz 48 angeordnet, welchem ein Vorladewiderstand 50 vorgeschaltet ist. An der Verbindungsstelle 28 ist die Nebenleitung 46 mit der Verbindungsleitung 16 gekoppelt, und an der Verbindungsstelle 30 ist sie an den Teil der Verbindungsleitung 16 angeschlossen, welche den Hauptschütz 20 mit dem Hochvoltanschluss 22 koppelt.

Der Zellstapel 14 kann, wie vorliegend beispielhaft gezeigt, einen im Wartungsfall zu ziehenden Schutzstecker 52 umfassen, welcher es ermöglicht, eine elektrische Verbindung innerhalb des Zellstapels 14 zu unterbrechen. Steckkontakte 54 des Schutzsteckers 52 stellen ebenfalls lösbare Verbindungsstellen dar, welche mittels eines Optokopplers 34 auf das Vorliegen unzulässig hoher Übergangswiderstände überwacht werden können. Auch hier bewirkt dann ein zu hoher Widerstand am Steckkontakt 54, dass der den jeweiligen Steckkontakt 54 überwachende Optokoppler 34 ein Signal an das Steuergerät 44 abgibt. In analoger Weise können lösbare Verbindungsstellen 56 überwacht werden, über welche eine (optionale) Sicherung 58 mit dem Schutzstecker 52 gekoppelt ist.

Wenn ein einziger Optokoppler 34 in einem Parallelzweig zu beiden Steckkontakten 54 vorgesehen ist, lässt sich mit diesem das Auftreten zu hoher Übergangswiderstände an allen im Bereich des Schutzsteckers 52 vorhandenen Verbindungsstellen 56 bzw. Steckkontakten 54 feststellen.

Dadurch, dass im Betrieb der Hochvoltbatterie 10 permanent die relevanten Übergangswiderstände an den lösbaren Verbindungsstellen 28, 30, 32, 54, 56 überwacht werden, kann ein besonders sicherer Betrieb der HochvoltBatterie 10 über ihre Lebensdauer hinweg sichergestellt werden.

Zudem kann beim Auftreten eines Fehlers in Form eines unzulässig hohen Widerstands an wenigstens einer der Verbindungsstellen 28, 30, 32, 54, 56 die Abgabe der elektrischen Leistung des Zellstapels 14 verringert oder unterbunden werden, sodass eine unerwünschte Überhitzung des Batteriesystems sicher vermeidbar ist.

## Patentansprüche

1. Batterie für ein Fahrzeug, mit einer Mehrzahl von Batteriezellen (12), welche einen Zellstapel (14) bilden, und mit wenigstens einer Leitung (16, 18), über welche im Betrieb der Batterie (10) elektrische Energie aus dem Zellstapel (14) entnehmbar oder in den Zellstapel (14) einbringbar ist,
**gekennzeichnet durch**
wenigstens eine Überwachungseinrichtung (34) zum Überwachen eines an zumindest einer lösbaren Verbindungsstelle (28, 30, 32, 54, 56) der wenigstens einen Leitung (16, 18) mit einer weiteren Komponente (20, 24, 52, 58) der Batterie (10) vorliegenden Widerstands, wobei die Überwachungseinrichtung (34) derart in einem Parallelzweig (38) zu der zumindest einen Verbindungsstelle (28, 30, 32, 54, 56) angeschlossen ist, dass bei stromführender Verbindungsstelle (28, 30, 32, 54, 56) an dem Parallelzweig (38) eine Spannung abfällt, wenn der Übergängswiderstand an der lösbaren Verbindungsstelle (28, 30, 32, 54, 56) einen zulässigen Höchstwert überschreitet.

2. Batterie nach Anspruch 1,
**dadurch gekennzeichnet, dass**
die wenigstens eine Überwachungseinrichtung einen Optokoppler (34) umfasst, dessen optischer Sender (36) parallel zu der zumindest einen Verbindungsstelle (32) geschaltet ist.

3. Batterie nach Anspruch 2,
**gekennzeichnet durch**
einen bidirektionalen Optokoppler (34).

4. Batterie nach Anspruch 2 oder 3,
**dadurch gekennzeichnet, dass**
dem optischer Sender (36) des Optokopplers (34) wenigstens ein Widerstandselement vorgeschaltet ist, mittels welchem ein Spannungswert festlegbar ist, bei dessen Überschreiten der optische Sender (36) Licht aussendet.

5. Batterie nach einem der Ansprüche 1 bis 4,
**dadurch gekennzeichnet, dass**
die wenigstens eine Überwachungseinrichtung (34) derart in dem Parallelzweig (38) an die Leitung (16, 18) angeschlossen ist, dass der Widerstand wenigstens zweier in Reihe geschalteter Verbindungsstellen (28, 30, 32, 54, 56) überwachbar ist.

6. Batterie nach einem der Ansprüche 1 bis 5,
**dadurch gekennzeichnet, dass**
die wenigstens eine Überwachungseinrichtung (34) mit einer Steuerungseinrichtung (44) gekoppelt ist, mittels welcher die Abgabe elektrischer Energie aus dem Zellstapel (14), insbesondere auf einen Wert Null, verringerbar ist.

7. Batterie nach einem der Ansprüche 1 bis 6,
**dadurch gekennzeichnet, dass**
die weitere Komponente wenigstens ein Schütz (20, 24) der Batterie (10) ist, wobei die Überwachungseinrichtung (34) in einem Parallelzweig (38) zu
- einem zellstapelseitigen Anschluss (28) des Schützes (20, 24) und/oder
- einem mit einem Hochvoltanschluss (22, 26) der Batterie (10) gekoppelten Anschluss (30, 32) des Schützes (20, 24) und/oder
- einem beide Anschlüsse (28, 30, 32) des Schützes (20, 24) umfassenden Laststrompfad des Schützes (20, 24) angeschlossen ist.

8. Batterie nach einem der Ansprüche 1 bis 7,
**dadurch gekennzeichnet, dass**
die weitere Komponente der Batterie (10) einen Schutzstecker (52) umfasst, mittels welchem eine elektrische Verbindung innerhalb des Zellstapels (14) zu unterbrechen ist.

9. Batterie nach Anspruch 8,
**dadurch gekennzeichnet, dass**
die weitere Komponente der Batterie (10) eine mit dem Schutzstecker (52) gekoppelte Sicherung (58) umfasst.

10. Verfahren zum Betreiben einer Batterie (10) für ein Fahrzeug, bei welcher eine Mehrzahl von Batteriezellen (12) einen Zellstapel (14) bildet, bei welchem über wenigstens eine Leitung (16, 18) elektrische Energie aus dem Zellstapel (14) entnommen oder in den Zellstapel (14) eingebracht wird,
**dadurch gekennzeichnet, dass**
ein an zumindest einer lösbaren Verbindungsstelle (28, 30, 32, 54, 56) der wenigstens einen Leitung (16, 18) vorliegender Widerstand mittels einer Überwachungseinrichtung (34) überwacht wird, welche derart in einem Parallelzweig (38) zu der zumindest einen Verbindungsstelle (28, 30, 32, 54, 56) angeschlossen ist, dass bei stromführender Verbindungsstelle (28, 30, 32, 54, 56) an dem Parallelzweig (38) eine Spannung abfällt, wenn der Übergangswiderstand an der lösbaren Verbindungsstelle (28, 30, 32, 54, 56) einen zulässigen Höchstwert überschreitet.

## Claims

1. Battery for a motor vehicle with a plurality of battery cells (12) which form a cell stack (14), and with at least one lead (16, 18) via which, when the battery is in operation, electrical energy can be taken from the cell stack (14) or fed into the cell stack (14), **characterised by**
at least one monitoring unit (34) for monitoring a resistance present on at least one breakable connection point (28, 30, 32, 54, 56) of the at least one lead (16, 18) with a further component (20, 24, 52, 58) of the battery (10), wherein the monitoring unit (34) is connected in a parallel branch (38) of the at least one connection point (28, 30, 32, 54, 56) is such a way that when the connection point (28, 30, 32, 54, 56) is live a voltage decreases on the parallel branch (38) if the transition resistance at the separable connection point (28, 30, 32, 54, 56) exceeds an admissible maximum value.

2. Battery according to claim 1
**characterised in that**
the at least one monitoring device comprises an optocoupler (34), the optical emitter (36) of which is connected in parallel with the at least one connection point (32).

3. Battery according to claim 2
**characterised by**
a bidirectional optocoupler (34)

4. Battery according to claim 2 or 3
**characterised in that**
connected upstream of the optical sensor (36) of the optocoupler (34) is at least one resistor element, by means of which a voltage value can be determined on the exceeding of which the optical emitter (35) emits light.

5. Battery according to any one of claims 1 to 4
**characterised in that** the at least one monitoring unit (34) is connected to the lead (16, 18) in the parallel branch (38) in such a way that the resistance of at least two connection points (28, 30, 32, 54. 56) connected in series can be monitored.

6. Battery according to any one of claims 1 to 5
**characterised in that**
the at least one monitoring device (34) is coupled to a control device (44) by means of which the emission of electrical energy from the cell stack (14) can, more particularly, be reduced to a value of zero.

7. Battery according to any one of claims 1 to 6 **characterised in that**
the further component is at least a contactor (20, 24) of the battery (10), wherein the monitoring device (34) is connected in a parallel branch (38) to
- a stack-side connection (28) of the contact (20, 24) and/or
- a connection (30, 32) of the contactor (20, 24) connected to a high-voltage connection (22, 26) of the battery (10), and/or
- a load current circuit of the contactor (20, 24) including both connections (28, 30, 32) of the contactor (20, 24)

8. Battery according to any one of claims 1 to 7
**characterised in that**
the further component of the battery (10) comprises a protective plug (52), by means of which an electrical connection is to be broken within the cell stack (14).

9. Battery according to claim 8
**characterised in that**
the further component of the battery (10) comprises a fuse (58) connected to the protective plug (52).

10. Method of operating a battery (10) for a motor vehicle, in which a plurality of battery cells (12) forms cell stack (14) in which at least via one lead (16, 18) electrical energy is taken from the cell stack (14) or fed into the cell stack (14)
**characterised in that**
a resistance on at least on breakable connection point (28, 30, 32, 54, 56) of the at least one lead (16, 18) is monitored by means of a monitoring device (34) which is connected in a parallel branch (38) to the at least one connection point (28, 30, 32, 54, 56) in such a way that when the connection point (28, 39, 32, 54, 56) is live, voltage on the parallel branch (38) decreases if the transition resistance at the breakable connection point (28, 30, 32, 54, 56) exceeds an admissible maximum value.

## Revendications

1. Batterie pour un véhicule, avec une multiplicité de cellules de batterie (12) qui forment une pile de cellules (14) et avec au moins un conducteur (16, 18) par l'intermédiaire duquel, lors du fonctionnement de la batterie (10), de l'énergie électrique peut être prélevée de la pile de cellules (14) ou peut être amenée dans la pile de cellules (14),
**caractérisée par**
au moins un dispositif de surveillance (34) pour surveiller une résistance présente en au moins un point de liaison amovible (28, 30, 32, 54, 56) de l'au moins un conducteur (16, 18) avec un autre composant (20, 24, 52, 58) de la batterie (10), le dispositif de surveillance (34) étant raccordé de telle sorte dans une branche parallèle (38) à l'au moins un point de liaison (28, 30, 32, 54, 56) que, lorsque le point de liaison (28, 30, 32, 54, 56) est conducteur de courant, une tension chute à la branche parallèle (38) lorsque la résistance de contact au point de liaison amovible (28, 30, 32, 54, 56) dépasse une valeur maximale autorisée.

2. Batterie selon la revendication 1, **caractérisée en ce que** l'au moins un dispositif de surveillance comprend un coupleur optoélectronique (34) dont l'émetteur optique (36) est branché en parallèle avec l'au moins un point de liaison (32).

3. Batterie selon la revendication 2, **caractérisée par** un coupleur optoélectronique (34) bidirectionnel.

4. Batterie selon la revendication 2 ou 3, **caractérisée en ce qu'**au moins un élément formant résistance est branché en amont de l'émetteur optique (36) du coupleur optoélectronique (34), élément formant résistance au moyen duquel peut être fixée une valeur de tension lors du dépassement de laquelle l'émetteur optique (36) émet de la lumière.

5. Batterie selon l'une des revendications 1 à 4, **caractérisée en ce que** l'au moins un dispositif de surveillance (34) est raccordé de telle sorte dans la branche parallèle (38) au conducteur (16, 18) que la résistance d'au moins deux points de liaison (28, 30, 32, 54, 56) branchés en série peut être surveillée.

6. Batterie selon l'une des revendications 1 à 5, **caractérisée en ce que** l'au moins un dispositif de surveillance (34) est couplé à un dispositif de commande (44) au moyen duquel la délivrance d'énergie électrique provenant de la pile de cellules (14) peut être réduite, notamment à une valeur nulle.

7. Batterie selon l'une des revendications 1 à 6, **caractérisée en ce que** l'autre composant est au moins un contacteur-interrupteur (20, 24) de la batterie (10), le dispositif de surveillance (34) étant raccordé dans une branche parallèle (38) à
- une borne (28), côté pile de cellules, du contacteur-interrupteur (20, 24) et/ou
- une borne (30, 32), couplée à une borne à haute tension (22, 26) de la batterie (10), du contacteur-interrupteur (20, 24) et/ou
- une voie de courant de charge, comprenant les deux bornes (28, 30, 32) du contacteur-interrupteur (20, 24), du contacteur-interrupteur (20, 24).

8. Batterie selon l'une des revendications 1 à 7, **caractérisée en ce que** l'autre composant de la batterie (10) comprend un connecteur de protection (52) au moyen duquel une liaison électrique à l'intérieur de la pile de cellules (14) doit être interrompue.

9. Batterie selon la revendication 8, **caractérisée en ce que** l'autre composant de la batterie (10) comprend un fusible (58) couplé au connecteur de protection (52).

10. Procédé de fonctionnement d'une batterie (10) pour un véhicule, selon lequel une multiplicité de cellules de batterie (12) forment une pile de cellules (14) et selon lequel, par l'intermédiaire d'au moins un conducteur (16, 18), de l'énergie électrique peut être prélevée de la pile de cellules (14) ou peut être amenée dans la pile de cellules (14),
**caractérisé en ce que**
une résistance présente en au moins un point de liaison amovible (28, 30, 32, 54, 56) de l'au moins un conducteur (16, 18) est surveillée au moyen d'un dispositif de surveillance (34) qui est raccordé de telle sorte dans une branche parallèle (38) à l'au moins un point de liaison (28, 30, 32, 54, 56) que, lorsque le point de liaison (28, 30, 32, 54, 56) est conducteur de courant, une tension chute à la branche parallèle (38) lorsque la résistance de contact au point de liaison amovible (28, 30, 32, 54, 56) dépasse une valeur maximale autorisée.
